# EUROPEAN PATENT APPLICATION

(11) **EP 0 893 824 A2**
(43) Date of publication of application: **27.01.1999**
(21) Application number: 97310091.0
(22) Date of filing: 15.12.1997
(51) Int. Cl.: H01L 21/762, H01L 21/316, H01L 21/3105

(54) **Method of forming a trench isolation structure utilizing composite oxide films**

(30) Priority: 25.07.1997 KR 9735212
(71) Applicant: Samsung Electronics Co., Ltd., Suwon-city, Kyungki-do (KR)
(72) Inventor: Park, Moon-han, Dongan-gu, Anyang-city, Kyungki-do (KR); Hong, Sug-hun, Eunpyung-gu, Seoul (KR); Shin, Yu-gyun, Kangnam-gu, Seoul (KR)
(74) Representative: Chugg, David John

(57) **Abstract**

A trench isolation method using two types of oxide films (22, 24) is provided. According to this method, a trench in a semiconductor substrate is filled by a composite film of two sequentially-stacked oxide films (22, 24) having different stress characteristics. The trench filling composite oxide film is densified. The trench filling composite oxide film is planarized until the upper surface of the mask layer is exposed. Thus, a trench filling layer is formed in the trench.

## Description

The present invention relates to a method for manufacturing a semiconductor device, and more particularly, to a trench isolation method capable of minimizing stresses generated on a silicon substrate.

In order to increase the integration density of semiconductor devices, an isolation method using a trench has been developed, and devices applying this method have been manufactured.

In a typical trench isolation method, a predetermined region of a semiconductor substrate is etched to form a trench region having a quadrilateral section, and an isolation film made of an insulating material is formed in the trench region. At this time, a process is performed to oxidize the trench inner sidewalls or to densify an insulating material filled in the trench region. This is to cure damage generated during etching to form the trench. In this process, stress is generated due to a difference in thermal expansion coefficient between the isolation film and the semiconductor substrate. The stress is concentrated in the semiconductor substrate around the isolation film, and especially around the corners of the trench. The accumulated stress in the semiconductor substrate causes a silicon defect such as dislocation in the semiconductor substrate. Such a silicon defect causes an increase of junction leakage current of the semiconductor device. As a result, the semiconductor device malfunctions, or power consumption increases.

It is an aim of embodiments of the present invention to provide a trench isolation method whereby stress in an isolation region of a semiconductor substrate can be relieved.

According to an aspect of the invention, there is provided a trench isolation method for a semiconductor device. In this method, a trench filling oxide film, comprised of a composite film formed of two sequentially-stacked layers having different stress characteristics, is formed on a semiconductor substrate on which a mask layer for exposing a trench region of the semiconductor substrate is formed. The trench filling oxide film is densified. The trench filling oxide film is planarized until the upper surface of the mask layer is exposed, to form a trench filling layer in the trench region.

The composite film is preferably formed by sequentially stacking first and second oxide films, which have opposite stress characteristics right after deposition.

Preferably, the first and second oxide films have tensile and compressive stress characteristics, respectively.

The first oxide film may be formed of a tetra-ethyl-orthosilicate (TEOS)-O₃ based chemical vapor deposition (CVD) oxide film.

The second oxide film may be formed of one selected from the group consisting of a TEOS based plasma enhanced CVD (PECVD) oxide film, an SiH₄ based PECVD oxide film and a high density plasma (HDP) oxide film.

Alternatively, the first and second oxide films may have compressive and tensile stress characteristics, respectively. The first oxide film may be formed of an HDP oxide film and the second oxide film may be formed of a TEOS-O₃ based CVD oxide film.

Preferably, prior to the step of forming the trench filling oxide film the following steps are carried out: forming a mask layer exposing a predetermined region of the semiconductor substrate, on the semiconductor substrate; dry-etching the exposed region of the semiconductor substrate to a predetermined depth using the mask layer as an etch mask, to form the trench region; and forming an oxide film on the sidewalls and the bottom surface of the trench region.

Said step of forming a mask layer preferably comprises the substeps of: forming a pad oxide film on the semiconductor substrate; forming a nitride film on the pad oxide film; and sequentially patterning the nitride film and the pad oxide film .

Said method preferably further comprises the step of forming a sacrificial oxide film on the nitride film after said step of forming a nitride film, and wherein the mask layer is formed by sequentially patterning the sacrificial oxide film, the nitride film and the pad oxide film.

The sacrificial oxide film may be formed by a thermal oxidation method.

Preferably, the oxide film is formed on the sidewalls and the bottom surface of the trench region by a thermal oxidation method.

Said step of densifying said trench filling oxide film preferably comprises thermally-treating the trench filling oxide film at a temperature of 1000°C to 1200°C.

Said step of planarizing the trench filling oxide film may be performed by chemical mechanical polishing (CMP).

Said step of planarizing the trench filling oxide film is preferably performed by an etch back method.

Preferably, the mask layer is removed using a wet-etch method after said step of forming a trench filling layer.

According to aspects of the present invention, during an initial deposition process and a subsequent thermal treatment of a trench filling oxide film, stress in the trench filling oxide film, and stress applied by the trench filling oxide film to a semiconductor substrate, are reduced.

For a better understanding of the invention, and to show how embodiments of the same may be carried into effect, reference will now be made, by way of example, to the accompanying diagrammatic drawings, in which:
Figures 1 through 5 are cross-sectional views illustrating a trench isolation method according to a preferred embodiment of the present invention;
Figure 6 is a graph showing stress hysteresis depending on the variation of temperature when a thermal treatment is performed for densifying a trench filling oxide film; and
Figure 7 is a graph showing a cumulative distribution of off-current characteristics of a transistor formed on the semiconductor substrate having trench isolation films formed thereon, in various conditions.

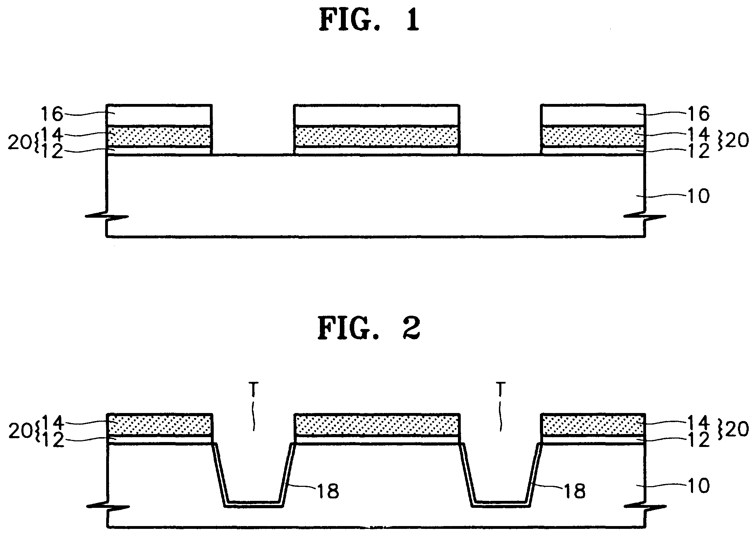

Referring to FIG 1, the step of forming a mask layer 20 and a sacrificial layer 16 on a semiconductor substrate 10 will now be described. First, a pad oxide film of a thickness 300Å or less, a nitride film of a thickness 2000Å or less, and a sacrificial oxide film of a thickness 3000Å or less are sequentially formed on the semiconductor substrate 10. The sacrificial oxide film is sacrificed to protect the nitride film during the formation of a trench region in a subsequent process, and is formed by a thermal oxidation method. The sacrificial oxide film can be omitted depending on circumstances. Next, the sacrificial oxide film, the nitride film and pad oxide film are sequentially patterned, to thereby form the sacrificial layer 16, and the mask layer 20 comprised of a pad oxide film pattern 12 and a nitride film pattern 14. The three layers expose a predetermined region of the semiconductor substrate 10.

The step of forming a trench region (T) is represented in Figure 2. Referring to Figure 2, the exposed portion of the semiconductor substrate 10 is selectively dry-etched using the mask layer 20 as an etch mask, to thus form the trench region (T) having a depth of about 10000Å or less. At this time, the sacrificial layer 16 is also etched and almost completely removed simultaneously with the formation of the trench region (T). Only a very thin oxide film (not shown) remains on the surface of the mask layer 20. Thereafter, in order to cure damage generated during the etching to form the trench region (T), an oxide film 18 is formed on the sidewalls and bottom surface of the trench region (T) using a thermal oxidation method.

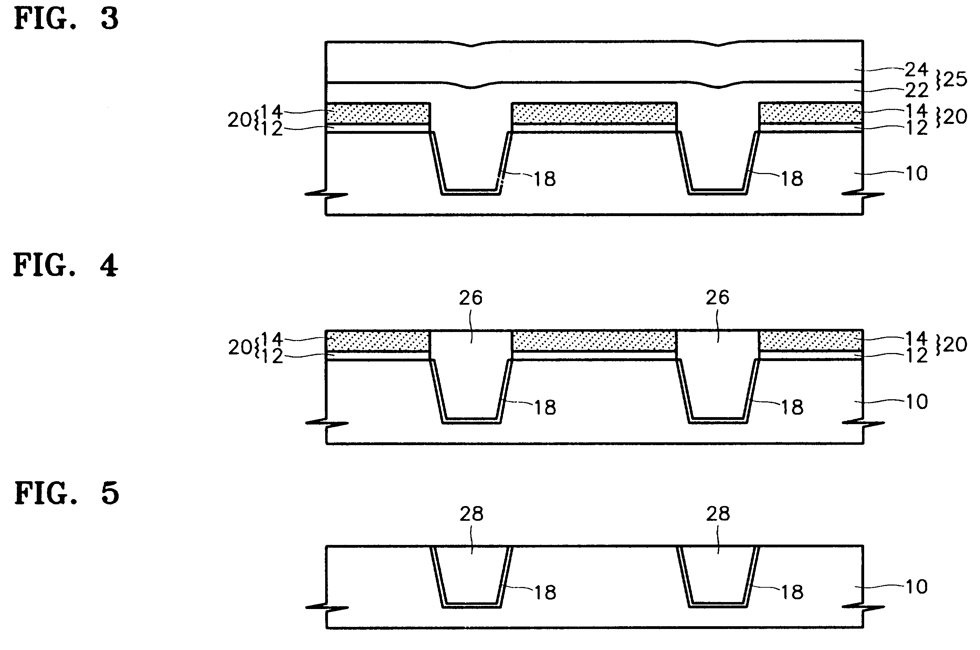

Figure 3 shows the step of forming a trench filling oxide film 25. In the present invention, the trench filling oxide film 25 is formed of a composite film comprised of two oxide films each having different stress characteristics right after a deposition. That is, in order to form the trench filling oxide film 25, a first oxide film 22 with a large tensile stress, having excellent trench filling characteristics, is formed to a predetermined thickness in the trench region (T) and on the upper surface of the nitride film pattern 14. Then, a second oxide film 24 with a larger compressive stress than the first oxide film 22 is formed to a predetermined thickness on the first oxide film 22. At this time, the sum of the thicknesses of the first and second oxide films 22 and 24 corresponds to the sum of the depth of the trench region (T), the thicknesses of the pad oxide film pattern 12 and nitride film pattern 14, and a thickness to be removed by etching in a subsequent planarization process. For instance, when the depth of the trench region (T) is 6000Å and the combined thickness of the pad oxide film 12 and the nitride film pattern 14 is 2000Å, the sum of the thicknesses of the first and second oxide films 22 and 24 is set to about 10000Å to allow about 2000Å to be removed in the subsequent planarization process.

For example, the first oxide film 22 may be formed on the basis of TEOS (tetra-ethyl-orthosilicate)-O₃ by a chemical vapor deposition (CVD) method. This is hereinafter called "a TEOS-O₃ based CVD oxide film". The second oxide film 24 may be formed, for example, on the basis of TEOS by a plasma enhanced CVD (PECVD) method, (hereinafter, called "a TEOS-O₃ based PECVD oxide film"), on the basis of SiH₄ by the PECVD method (hereinafter, called as "SiH₄ based PECVD oxide film"), or of a high density plasma (HDP) oxide film. Alternately, the first oxide film 22 can be an HDP oxide film. In this case, the second oxide film 24 is the TEOS-O₃ based CVD oxide film.

The reason why the trench filling oxide film 25 is formed of a composite film comprised of two layers as described above is as follows. In the case that a trench filling layer is formed by depositing only a CVD oxide film based on a filling material (e.g., TEOS-O₃) for filling the trench region by a typical method, the trench filling layer right after being deposited has a tendency to become porous. Accordingly, if a subsequent wet etching process is immediately carried out using an etchant such as a HF solution with respect to the trench filling layer, without conducting a post processing, an excessive portion of the trench filling layer is etched. As a result, it is difficult to obtain a trench isolation film having a desired profile. Therefore, a technique of densifying the trench filling layer by performing a thermal treatment at a temperature of 1000°C or more is often used after forming the trench filling layer. However, it has not been generally recognized that an initial stress is generated right after the trench filling layer is formed, and a thermal stress is generated during the above thermal treatment at a high temperature. An experiment was performed to measure stress in the trench filling layer, when only a single oxide film is used as a filling material for filling the trench region, like in a typical method, and when a TEOS-O₃ based CVD oxide film, exhibiting tensile stress, is formed as the single oxide film. As the result of this experiment, the oxide film was found to have a high tensile stress of the order of 10⁹ dyne/cm², right after being deposited. Also, when the temperature reaches about 700°C during a thermal treatment for densifying the oxide film, the high tensile stress becomes of the order of 10¹⁰ dyne/cm², so that the oxide film applies stress to the silicon substrate. Consequently, in the case that the trench filling layer is formed of an oxide film having stress characteristics of only one aspect, e.g., a single film comprised of only the TEOS-O₃ based CVD oxide film exhibiting tensile stress, the initial stress right after being deposited and the stress generated during the thermal treatment for densification increase. Thus, the probability of defects in the semiconductor device becomes higher. Concrete experimental data on the above result will be described later.

According to the teachings of the present invention, in order to lower the initial stress of the trench filling material layer and the excess stress generated during the thermal treatment, the trench filling oxide film 25 is formed of a composite film comprised of two oxide films having opposite stress characteristics right after being deposited. That is, the two oxide films are the first oxide film 22 with a tensile stress and the second oxide film 24 with a compressive stress. The trench filling oxide film may also be formed of a composite film comprised of a first oxide film with a compressive stress and a second oxide film with a tensile stress.

Thereafter, the trench filling oxide film 25 is thermally treated at a temperature of about 1000 to 1200°C, to be densified.

Figure 4 is a sectional view explaining the step of planarizing the trench filling oxide film. The trench filling oxide film 25 is planarized by a chemical mechanical polishing (CMP) method until the nitride film pattern 14 used as an etching prevention layer is exposed, thereby forming a trench filling layer 26 in the trench region (T).

Figure 5 shows the step of forming an isolation film. To be more specific, the exposed nitride film pattern 14 is removed by a nitride film etchant. Next, the pad oxide film pattern 12 is removed by an oxide film etchant, to thereby expose the surface of the semiconductor substrate 10, i.e., an active region. As a result, the isolation film 28 is formed having a height approximately the same as the surface height of the active region.

According to the preferred embodiment of the present invention as described above, a trench filling oxide film is formed of a composite film comprised of two oxide films having opposite stress characteristics. Thus, during the initial deposition and the subsequent thermal treatment of the trench filling oxide film, stress in the trench filling oxide film and stress applied by the trench filling oxide film to the semiconductor substrate are reduced. Consequently, the generation of silicon defects due to the stress in the semiconductor substrate can be suppressed.

Table. 1 illustrates the results of an experiment for evaluating the effects of the trench isolation method according to the present invention. In this experiment, the first and second oxide films constituting the trench filling oxide film are deposited to various thicknesses to form the trench filling oxide film having a total thickness of 10000Å. Then, initial stress in the trench filling oxide film was immediately measured. Here, the first oxide film was formed of the TEOS-O₃ based CVD oxide film with a compressive stress. The second oxide film was formed of the TEOS based PECVD oxide film with a tensile stress.

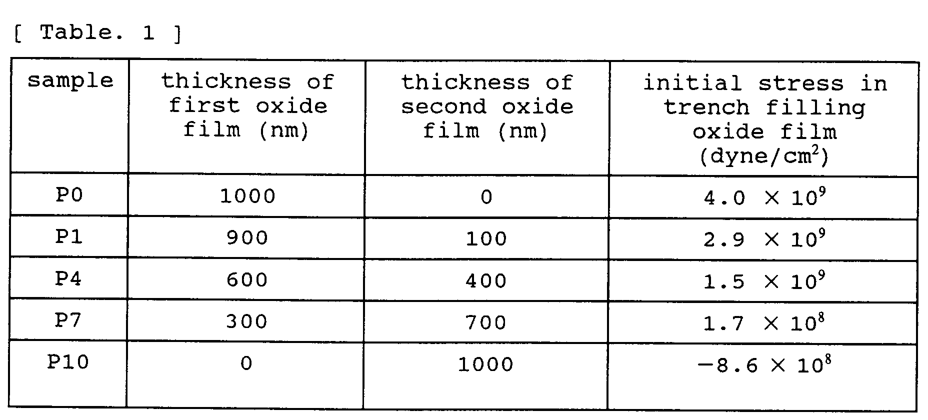

Through the results of Table. 1, we can see that the initial stress decreases as the second oxide film becomes thicker than the first oxide film.

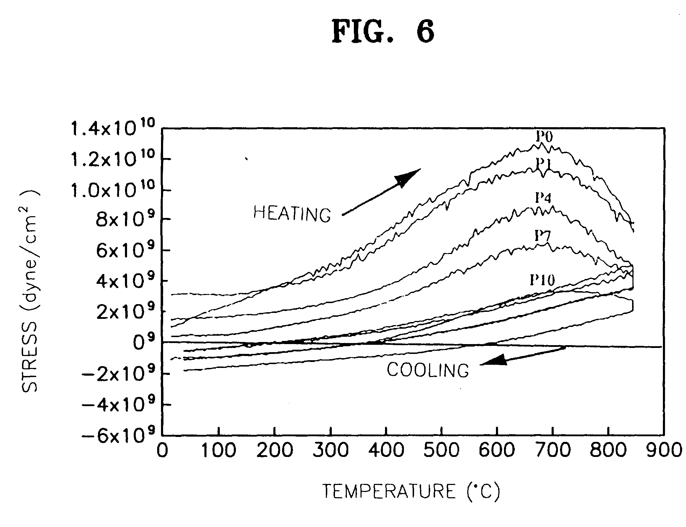

Figure 6 is a graph showing stress hysteresis generated depending on a change in temperature when performing a thermal treatment for densification of the trench filling oxide film of each sample of Table. 1. The data of Figure 6 began to be measured about thirty minutes after the measurement of the results of Table. 1. Here, it can be seen that the initial stress, i.e., stress at a normal temperature is different from the result of Table. 1 in the case of P0. The reason is that when the trench filling oxide film is formed only of the TEOS-O₃ based CVD oxide film, moisture in the air begins to be absorbed into the oxide film right after the oxide film is formed. This influenced the results of Figure 6.

Figure 6 shows that the peak stress generated during the thermal treatment appears as follows: P0 > P1 > P4 > P7 > P10. That is, it can be found that a smaller stress is generated during the thermal treatment as the second oxide film becomes thicker than the first oxide film.

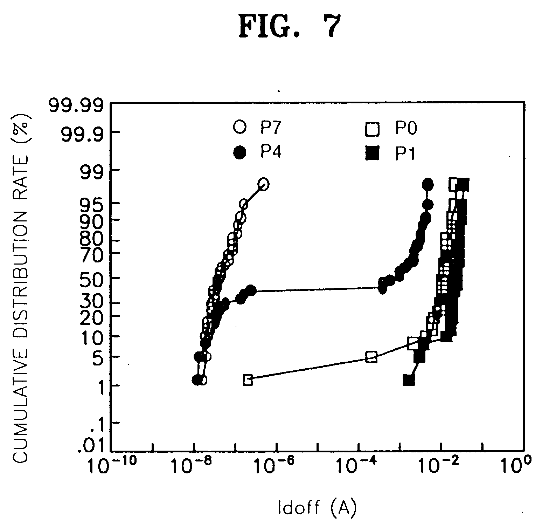

Figure 7 is a graph showing cumulative distribution of off-current characteristics of transistors formed on the semiconductor substrate having the trench isolation film formed under the conditions of each sample in Table. 1.

From Figure 7, it can be seen that the off-current decreases as the defect density in the semiconductor substrate decreases. That is, when the stress in the trench filling oxide film is large, many defects are generated in the semiconductor substrate, and thus off-current fail also increases.

According to the preferred embodiment of the present invention as described above, a trench filling oxide film is a composite film comprised of two oxide films having opposite stress characteristics. Thus, during the initial deposition and the subsequent thermal treatment of the trench filling oxide film, stress in the trench filling oxide film and stress applied by the trench filling oxide film to the semiconductor substrate are reduced. Consequently, the generation of silicon defects due to the stress in the semiconductor substrate can be suppressed.

Though the present invention was described in detail referring to the preferred embodiment, it is not limited to the above embodiment. Various modifications may be effected by those skilled in the art, within the range of the technical spirit of the present invention.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A trench isolation method for a semiconductor device, comprising the steps of:
forming a trench filling oxide film (25), comprised of a composite film formed of two sequentially-stacked layers (22, 24) having different stress characteristics, on a semiconductor substrate (10) on which a mask layer (20) for exposing a trench region of the semiconductor substrate (10) is formed;
densifying the trench filling oxide film (25); and
planarizing the trench filling oxide film (25) until the upper surface (14) of the mask layer (20) is exposed, to form a trench filling layer in the trench region.

2. The trench isolation method as claimed in claim 1, wherein the composite film (25) is formed by sequentially stacking first and second oxide films (22, 24), which have opposite stress characteristics right after deposition.

3. The trench isolation method as claimed in claim 2, wherein the first and second oxide films (22, 24) have tensile and compressive stress characteristics, respectively.

4. The trench isolation method as claimed in claim 3, wherein the first oxide film (22) is formed of a tetra-ethyl-orthosilicate (TEOS)-O₃ based chemical vapor deposition (CVD) oxide film.

5. The trench isolation method as claimed in claim 3 or 4, wherein the second oxide film (24) is formed of one selected from the group consisting of a TEOS based plasma enhanced CVD (PECVD) oxide film, an SiH₄ based PECVD oxide film and a high density plasma (HDP) oxide film.

6. The trench isolation method as claimed in claim 2, wherein the first and second oxide films (22, 24) have compressive and tensile stress characteristics, respectively.

7. The trench isolation method as claimed in claim 6, wherein the first oxide film (22) is formed of an HDP oxide film.

8. The trench isolation method as claimed in claim 6, wherein the second oxide film (24) is formed of a TEOS-O₃ based CVD oxide film.

9. The trench isolation method as claimed in any of the preceding claims wherein prior to the step of forming the trench filling oxide film the following steps are carried out:
forming a mask layer (20) exposing a predetermined region of the semiconductor substrate, on the semiconductor substrate (10);
dry-etching the exposed region of the semiconductor substrate (10) to a predetermined depth using the mask layer (20) as an etch mask, to form the trench region; and
forming an oxide film (18) on the sidewalls and the bottom surface of the trench region.

10. The trench isolation method as claimed in claim 9, wherein said step of forming a mask layer comprises the substeps of:
forming a pad oxide film (12) on the semiconductor substrate (10);
forming a nitride film (14) on the pad oxide film (12); and
sequentially patterning the nitride film (14) and the pad oxide film (12).

11. The trench isolation method as claimed in claim 10, wherein said method further comprises a step of forming a sacrificial oxide film (16) on the nitride film (14) after said step of forming a nitride film (14), and wherein the mask layer (20) is formed by sequentially patterning the sacrificial oxide film (16), the nitride film (14) and the pad oxide film (12).

12. The trench isolation method as claimed in claim 11, wherein the sacrificial oxide film (16) is formed by a thermal oxidation method.

13. The trench isolation method as claimed in any of claims 9 to 12 wherein the oxide film (18) is formed on the sidewalls and the bottom surface of the trench region by a thermal oxidation method.

14. The trench isolation method as claimed in any of the preceding claims wherein said step of densifying said trench filling oxide film (25) comprises thermally-treating the trench filling oxide film at a temperature of 1000°C to 1200°C.

15. The trench isolation method as claimed in any of the preceding claims, wherein said step of planarizing the trench filling oxide film (25) is performed by chemical mechanical polishing (CMP).

16. The trench isolation method as claimed in any of claims 1 to 14, wherein said step of planarizing the trench filling oxide film is performed by an etch back method.

17. The trench isolation method as claimed in any of the preceding claims further comprising removing the mask layer (20) using a wet-etch method after said step of forming a trench filling layer (25).
